# EUROPÄISCHE PATENTSCHRIFT

(11) **EP 2 780 993 B1**
(45) Veröffentlichungstag und Bekanntmachung des Hinweises auf die Patenterteilung: **20.01.2016**
(21) Anmeldenummer: 12791126.1
(22) Anmeldetag: 07.11.2012
(51) Int. Cl.: H02G 1/12

(54) **LITZENSCHNITTERKENNUNG**
DETECTION OF CUT LITZ WIRES
DÉTECTION D'UNE ENTAILLE SUR UN TORON

(30) Priorität: 14.11.2011 DE 202011107872 U
(43) Veröffentlichungstag der Anmeldung: 24.09.2014
(73) Patentinhaber: Schäfer Werkzeug- und Sondermaschinenbau GmbH, 76669 Bad Schönborn-Langenbrücken (DE)
(72) Erfinder: NEUBAUER, Stefan, 67166 Otterstadt (DE); SCHÄFER, Markus, 76669 Bad Schönborn (DE)
(74) Vertreter: Hoffmann Eitle
(86) Internationale Anmeldenummer: PCT/EP2012/072008
(87) Internationale Veröffentlichungsnummer: WO 2013/072229

(56) Entgegenhaltungen:
- EP-A1- 0 195 932
- EP-A1- 0 524 121
- DE-A1-102007 053 825
- DE-A1-102009 027 967
- JP-A- H07 236 214
- JP-A- H11 299 036

## Beschreibung

### Technisches Gebiet

Die vorliegende Erfindung betrifft Abisoliervorrichtungen, mit denen ein Kabelmantel von einem Kabelende entfernt und auf diesem Wege die Kabelader freigelegt werden kann.

### Stand der Technik

Im Bereich der Abisoliervorrichtungen sind solche bekannt, die zwei gegenüber liegende V-förmige Messerhälften aufweisen. Beim Abisoliervorgang werden diese Messerhälften aufeinander zu bewegt und durch die Isolierung gedrückt. Anschließend werden die Messerhälften jeweils in eine zu dieser Zustellbewegung entgegengesetzte Richtung bewegt, bleiben jedoch weiter mit dem Kabelmantel in Eingriff. Im nachfolgenden Verfahrensschritt werden die Messerhälften in einer zur Längsrichtung des Kabels parallelen Richtung bewegt, um den Kabelmantel abzustreifen.

Allerdings besteht darin ein Problem, dass beispielsweise auf Grund von Qualitätsschwankungen bei den Kabeln oder bei einer nicht präzisen Ausrichtung der Kabel relativ zu den Messerhälften die Messerhälften beim Abisolieren zu tief in das Kabel eindringen. Dadurch besteht die Gefahr, dass durch die Schneidflächen der Messerhälften Litzen der Kabelader beschädigt werden. Sollte durch diesen Vorgang eine Litze durchtrennt und beim Abstreifen des Kabelmantels mit abgezogen werden, weist dieses schadhafte Kabel eine Kabelader auf, die sich im Durchmesser beziehungsweise in der Durchmessergestalt von solchen unterscheidet, die beim Abisolieren unbeschädigt verblieben sind. Dies hat zur Folge, dass beim anschließenden Vercrimpen der Kabelader mit einem Crimpelement nicht mehr die nötige Crimpkraft aufgebracht wird, und somit eine fehlerhafte Verbindung zwischen Kabelader und Crimpelement hergestellt wird.

Handelt es sich bei dem abisolierten Kabel um einen Aluminiumleiter, ergibt sich durch das Einschneiden einer der Messerhälften in die Kabelader zusätzlich darin ein Problem, dass mit dem Messer die schützende Oxidschicht des Aluminiums entfernt wird und es an dieser Stelle zur Korrosion der Kabelader kommt. Dies wiederum kann beim Vercrimpen oder auch zu einem späteren Zeitpunkt zu einer fehlerhaften Crimpverbindung führen.

Das Dokument DE 10 2009 027 967 A1 zeigt ein Verfahren zum Abisolieren einer Leitung, die eine auf mindestens einem elektrischen Leiter angeordnete Ummantelung umfasst, bei dem ein Abisolieren der Ummantelung mit Hilfe mindestens eines Abisolierwerkzeugs vorgenommen wird, indem die Ummantelung des mindestens einen elektrischen Leiters zumindest angeschnitten wird. Dabei ist es vorgesehen, dass das Abisolierwerkzeug und der mindestens eine elektrische Leiter der Leitung über eine elektrische Verbindung unter Anlegen einer vorgebbaren Spannung miteinander verbunden werden, wodurch beim Abisolieren der Leitung dann ein Stromfluss registriert wird, wenn das Abisolierwerkzeug mit dem elektrischen Leiter der Leitung einen Stromkreis bildet.

Weitere Dokumente sind JP H11 299 036 A, DE 10 2007 05 38 25 A1 sowie JP H07 236214 A.

### Gegenstand der Erfindung

Ein Ziel der vorliegenden Erfindung ist es, die zuvor genannten Probleme zu lösen, und die Qualität von Crimpverbindungen bereits beim Abisolieren der Kabelenden zu gewährleisten.

Die erfindungsgemäße Aufgabe wird durch eine Vorrichtung gemäß Anspruch 1.

Dabei ist der Kerngedanke der vorliegenden Erfindung, ein Abisolieren während des gesamten Abisoliervorgangs zu überwachen, indem an die zum Abisolieren verwendeten Messerhälften eine Spannung angelegt wird. Sollten die Messerhälften mit der Kabelader in Kontakt treten, wird ein Stromkreislauf geschlossen, und somit angezeigt, dass ein fehlerhaftes Kabelende zu erwarten ist. Folglich wird ein solches Kabel aussortiert, sodass keine fehlerhaften Kabel zum nachgeschalteten Crimpvorgang gelangen.

Hierfür stellt die vorliegende Erfindung eine Abisoliervorrichtung zum Abisolieren eines Kabelmantels mit einer ersten Messerhälfte und einer zweiten Messerhälfte bereit. Die Messerhälften sind in einer ersten Richtung (bspw. vertikale Richtung) bewegbar. Insbesondere können die Messerhälften zum Abisolieren eines Kabelmantels aufeinander zu bewegt werden. Die zueinander weisenden Seitenflächen der ersten und zweiten Messerhälfte sind in einer zur ersten Richtung im Wesentlichen senkrechten zweiten Richtung (bspw. horizontale Richtung) mit einem Abstand voneinander beabstandet. Durch diesen Abstand wird sichergestellt, dass sich die Messerhälften gegebenenfalls abschnittsweise überlappen können, ohne miteinander in Eingriff zu geraten, selbst wenn die Messerhälften beim Abisolieren oder Abstreifen des Kabelmantels verformt werden. An der aus einem leitenden Material hergestellten ersten und zweiten Messerhälfte ist eine Spannung angelegt. Ferner weist die Abisoliervorrichtung eine mit der ersten Messerhälfte und der zweiten Messerhälfte verbundene Auswerteeinheit auf, die einen Stromfluss durch die erste Messerhälfte und die zweite Messerhälfte erfassen kann. Besonders bevorzugt ist es hierbei, dass es sich um einen Stromfluss zwischen den beiden Messerhälften handelt. In einer weiteren Zielrichtung könnte durch die Auswerteeinheit ein Stromfluss durch die erste Messerhälfte und/oder die zweite Messerhälfte erfasst werden.

Auf diese Weise kann erfasst werden, ob die Messerhälften die Kabelader berühren und somit gegebenenfalls Litzen aus dem Kabelader heraustrennen. Eine solche Erfassung kann mit der Auswerteeinheit während des Abisolierens durchgeführt werden. Demnach handelt es sich um eine einfache technische Maßnahme, mit der der Fertigungsprozess nicht verlängert wird. Da die Auswerteeinheit vollautomatisch arbeitet, sind keine weiteren Maßnahmen zur Qualitätssicherung für einen möglichen "Litzenschnitt" notwendig.

Gemäß einer Ausführungsform weisen die Messerhälften jeweils eine V-förmige Schneidkante auf. Auf diese Weise kann ein Kabel von mehreren Seiten beschnitten werden. Dadurch kann das Abisolieren einfach und sicher durchgeführt werden.

Gemäß einer weiteren Ausführungsform sind an den Messerhälften Anschlüsse angebracht bzw. integral mit den Messerhälften ausgestaltet, über die die Auswerteeinheit mit der jeweiligen Messerhälfte verbunden ist. Handelt es sich um "Standardmesserhälften", die ohne die hier beschriebene Erfassung einer Beschädigung der Kabelader eingesetzt werden, könnte ein solcher Kontakt bspw. angeklemmt werden.

In einer Ausführungsform ist die Isolierung im Wesentlichen L-förmig ausgebildet, sodass ein Längsbereich der Isolierung an einer Seitenfläche der Messerhälfte anliegt, und ein Querbereich an einer Rückfläche der Messerhälfte. Somit wird die leitende Messerhälfte von dem üblicherweise metallischen Halter isoliert, wodurch an dieser Stelle keine Messfehler auftreten können. Beispielsweise kann die Isolierung aus einem Keramikmaterial gefertigt sein, was die Lagegenauigkeit der Messerhälfte sicherstellt.

In einer anderen Ausführungsform ist die Isolierung als eine Beschichtung, bspw. eine Keramikbeschichtung, eines Abschnitts der ersten Messerhälfte und/oder der zweiten Messerhälfte ausgebildet. Diese Isolierung stellt ebenfalls sicher, dass die leitenden Messerhälften vom jeweiligen Halter getrennt sind. In wieder einer anderen Ausgestaltung weist die erste und/oder die zweite Messerhälfte eine Ausnehmung auf, in die die als Block ausgebildete Isolierung eingelegt und befestigt wird, wobei die Isolierung über eine Seitenfläche der jeweiligen Messerhälfte hervorsteht. Durch dieses Hervorstehen der Isolierung kann die jeweilige Messerhälfte vom Halter beabstandet werden, sodass ein gewisser Abstand zwischen den beiden Messerhälften in der zweiten Richtung ausgebildet wird.

Ferner können Messerhälften vorgesehen sein, die abgesetzte Bereiche aufweisen, die im eingebauten Zustand der jeweiligen Messerhälfte in Richtung der anderen Messerhälfte und zu einer Seitenfläche dieser Messerhälfte weisen. Jedoch ist es möglich, den Abstand zwischen den Messerhälften in der zweiten Richtung zu verringern, und gleichzeitig zu gewährleisten, dass beim Abziehen des Kabelmantels und einer damit verbundenen leichten Durchbiegung der Messerhälften kein Kontakt zwischen diesen hergestellt wird. Dies würde dazu führen, dass fälschlicher Weise ein schadhaftes Kabel angenommen wird.

In einer weiteren Ausführungsform wird eine Abisoliervorrichtung bereitgestellt, die mehrere erste Messerhälften (sowie mehrere zweite Messerhälften aufweist. Mit einer solchen Vorrichtung können mehrere Kabel parallel durch eine gemeinsame Hub- und Abziehbewegung der Messerhälften abisoliert werden.

Ferner kann die Auswerteeinheit zusätzlich mit der Kabelader des zu bearbeitenden Kabels verbunden sein. Auf diese Weise kann ein Kontakt einer Messerhälfte mit der Kabelader erfasst werden. Das Ergebnis dieser Erfassung kann beispielsweise dazu führen, dass diese Kabel aussortiert wird, da eine mögliche Beschädigung vorliegt.

Auch ist es denkbar, einen 2-stufigen Test auszuführen, nämlich (1) Kontakt eine Messerhälfte mit Kabelader, und (2) Kontakt beide Messerhälften mit Kabelader. Bei (1) kommt es zu einem Stromfluss zwischen einer Messerhälfte und der Kabelader, bei (2) zusätzlich zwischen beiden Messerhälften. Dies könnte besonders bevorzugt in einem Verfahren eingebunden werden.

Dabei ist es denkbar, mit dem beschriebenen Test auf Grundlage der Materialart der Kabelader eine Entscheidung zu treffen, ob ein schadhaft abisoliertes Kabel vorliegt.

### Gemäß einer weiteren Zielrichtung

wird eine Abisoliervorrichtung zum Abisolieren eines Kabelmantels eines Kabels mit einer ersten Messerhälfte und einer zweiten Messerhälfte bereitgestellt, die in einer ersten Richtung (Y) aufeinander zu bewegbar sind. Die zueinander weisenden Seitenflächen der ersten und zweiten Messerhälfte sind in einer zur ersten Richtung im Wesentlichen senkrechten zweiten Richtung (X) mit einem Abstand voneinander beabstandet, an der ersten Messerhälfte und der zweiten Messerhälfte ist eine Spannung angelegt, und die Abisoliervorrichtung weist ferner eine mit der ersten Messerhälfte und der zweiten Messerhälfte verbundene Auswerteeinheit auf, die einen Stromfluss durch die erste Messerhälfte und/oder die zweite Messerhälfte erfassen kann, wobei eine Isolierung der ersten und/oder zweiten Messerhälfte im Wesentlichen L-förmig ausgebildet ist, sodass ein Längsbereich an einer Seitenfläche der Messerhälfte anliegt, und ein Querbereich an einer Rückfläche der Messerhälfte anliegt.

Die Abisoliervorrichtung gemäß dieser Zielrichtung kann mit zuvor genannten bevorzugten Ausführungsformen kombiniert werden, um neue Ausführungsformen auszubilden.

### Kurze Beschreibung der Zeichnungen

- Figur 1: zeigt eine schematische Schnittansicht zweier ausgefahrener Messerhälften;
- Figur 2: zeigt eine weitere Ausführungsform zweier ausgefahrener Messerhälften;
- Figur 3a: zeigt eine Draufsicht einer an einem Halter befestigten Messerhälfte;
- Figur 3b: zeigt eine Draufsicht einer alternativen Ausführungsform einer Messerhälfte gemäß der vorliegenden Erfindung;
- Figur 4: ist eine schematische Darstellung eines Abisolieraggregats zum Abisolieren von drei Kabelenden;
- Figur 5: zeigt ein Diagramm, dass eine Zustellbewegung einer der Messerhälften beim Abisolieren eines Kabelendes zeigt.

### Detaillierte Beschreibung der bevorzugten Ausführungsformen

Nachfolgend werden vor dem Hintergrund der beigefügten Figuren bevorzugte Ausführungsformen der vorliegenden Erfindung und deren Modifikationen rein beispielhaft beschrieben. Einzelmerkmale der beschriebenen Varianten können miteinander kombiniert werden, um neue Ausführungsformen auszubilden.

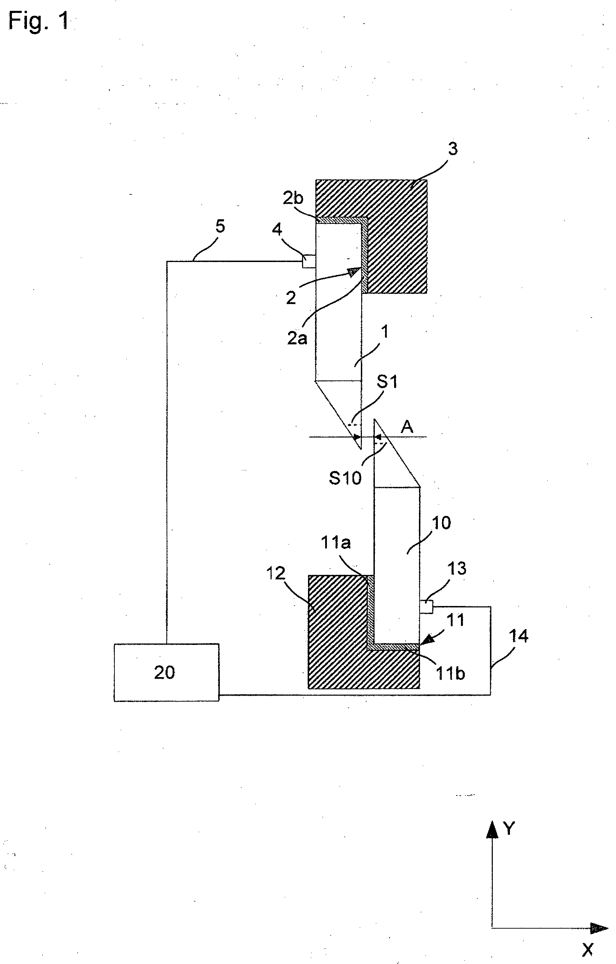

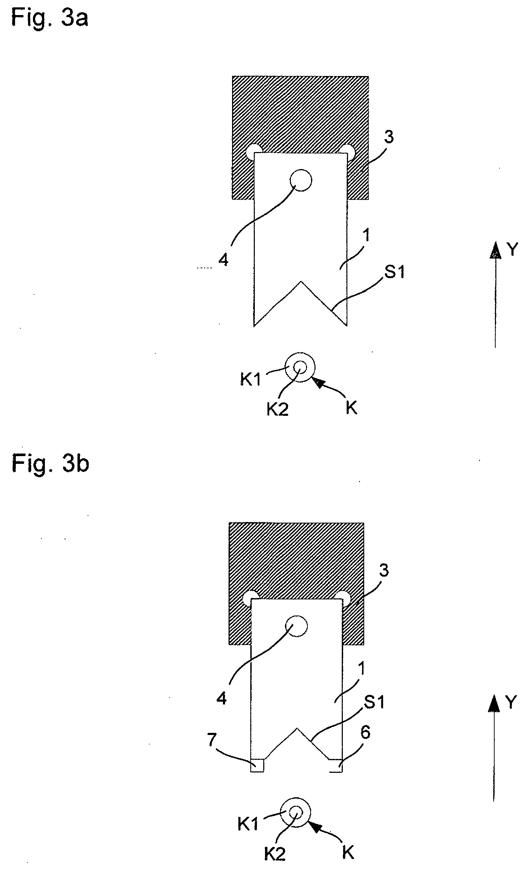

Figur 1 zeigt eine erste Messerhälfte 1, deren Geometrie später unter Bezugnahme auf Figuren 3a und 3b genauer beschrieben wird. Die erste Messerhälfte 1 ist mit einer Isolierung 2 versehen, über die die erste Messerhälfte 1 an einem Halter 3 angebracht und gegenüber diesem isoliert ist.

Im Wesentlichen spiegelbildlich zur ersten Messerhälfte 1 ist eine zweite Messerhälfte 10 vorgesehen, die ebenfalls über eine Isolierung 11 mit einem Halter 12 in Verbindung steht. Die Isolierungen 2, 11 können am jeweiligen Halter bspw. angeschraubt, angeklebt oder auf eine andere Weise fest angebunden werden.

Die Halter 3 und 12 sind aufeinander zu bewegbar, wodurch die Messerhälften 1, 10 abschnittsweise aneinander vorbei geführt werden. Hierbei bildet sich zwischen einer Seitenfläche des Messers 1 und einer Seitenfläche des zweiten Messers 10 ein Abstand A zwischen den Messerhälften 1, 10 aus.

In Figur 1 sind die aus einem leitenden Material (bspw. einem Metall) hergestellten Messerhälften 1, 10 in einer ausgefahrenen Position gezeigt. Da die Messerhälften V-förmige Schneidkanten S1, S10 aufweisen (siehe auch Figuren 3a, 3b), bildet sich bei einer Draufsicht auf die Messerhälften 1, 10 ein rautenförmiger Spalt aus, durch den zumindest eine Kabelader dringen kann. Der Kabelmantel hingegen wird in einem ausgestellten Zustand der Messerhälften zumindest abschnittsweise von den Schneidkanten S1, S10 durchdrungen.

An der ersten Messerhälfte 1 ist an einer vom Halter 3 weg weisenden Seitenfläche ein Anschluss 4 vorgesehen, an dem über ein Leitungskabel 5 eine Spannung an der leitenden Messerhälfte 1 angelegt werden kann. Ebenso ist an der zweiten Messerhälfte 10 an einer vom Halter 12 weg weisenden Seitenfläche ein Anschluss 13 vorgesehen, an dem über ein Leitungskabel 14 eine Spannung an der metallischen zweiten Messerhälfte 10 angelegt werden kann.

Die Anschlüsse 4, 13 können hierbei an die Messerhälften 1, 10 angeschraubt, angeschweißt, angelötet oder angeklemmt werden. Alternativ ist es möglich, Messerhälften mit einem integralen Anschluss für ein Leitungskabel bereit zu stellen.

Die Leitungskabel 5, 13 sind mit einer Auswerteeinheit 20 verbunden. Die Auswerteeinheit 20 kann bewerten, ob durch die Leitungskabel 5, 13 ein Strom fließt, was darauf hindeutet, dass über die Kabelader K2 zwischen den Messerhälften 1, 10 ein Kontakt hergestellt wurde.

Alternativ oder zusätzlich ist es möglich, die Auswerteeinheit auch mit der Kabelader K2 zu verbinden. Denn obwohl insbesondere bei symmetrischer Ausgestaltung der Messerhälften beide Messerhälften gleich weit in die Isolierung eindringen und somit das Kabelader im Wesentlichen gleichzeitig berühren, könnte es sein, dass nur eine Messerhälfte zu weit eindringt. In diesem Fall würde der Strom durch die weiter eingedrungene Messerhälfte und durch die Kabelader fließen. Auch dies könnte erfasst werden.

Die Messerhälften 1, 10 sind mit jeweils einer Isolierung 2, 11 am entsprechenden Halter 3, 12 angebunden. In der in Figur 1 gezeigten Ausführungsform ist die Isolierung 2, 11 im Wesentlichen L-förmig ausgebildet. Hierbei weist die Isolierung 2 einen Längsbereich 2a auf, der an einer Seitenfläche der ersten Messerhälfte 1 anliegt, und die Isolierung 2 weist einen Querbereich 2b auf, der mit einer Endseite der ersten Messerhälfte 1 in Kontakt ist. Der Querbereich weist eine derartige Dicke auf, dass der in Figur 1 gezeigte Abstand A zur Hälfte ausgebildet wird (½ x A). Durch diese Ausgestaltung wird sichergestellt, dass weder die Endseite der ersten Messerhälfte 1 noch deren Seitenfläche mit dem Halter 3 in Kontakt kommt. Andernfalls würde auch an den Haltern 3, 12 eine Spannung angelegt wird.

Der Abstand kann z.B. 0,001 mm betragen. Dies gewährleistet ausreichende Scherkräfte und verhindert einen Kontakt der Messerhälften. Andere Abstände, z.B. im Bereich von 0,00005 ≤ A ≤ 0,01 mm sind je nach Verformungswiderstand der Messerhälften denkbar.

Die Isolierung 11 der zweiten Messerhälfte 10 ist entsprechend zur Isolierung 2 ausgebildet, und weist ebenso einen Längsbereich 11a und einen Querbereich 11b auf, die mit einer Seitenfläche und einer Rückfläche der zweiten Messerhälfte 10 sowie dem Halter 12 in Kontakt stehen. Die Isolierung verhindert einen Kontakt zwischen der zweiten Messerhälfte 10 und dem Halter 12.

Im Ergebnis ist auf diese Weise sichergestellt, dass der von der Auswerteeinheit 20 überwachte Stromfluss nicht über das Abisolieraggregat hergestellt wird.

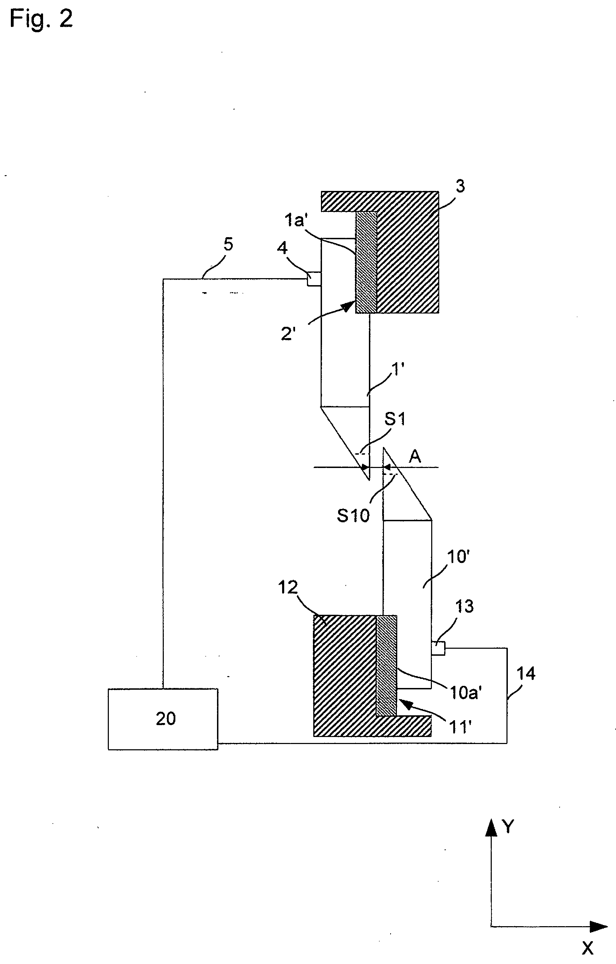

In Figur 2 ist eine weitere Ausführungsform mit einer ersten Messerhälfte 1' und zweite Messerhälfte 10' der vorliegenden Erfindung gezeigt. Die Isolierungen 2', 11' sind hierbei in Ausnehmungen 1a', 10a' an einer Seitenfläche der ersten Messerhälfte 1' eingebracht, wobei die Isolierungen 2', 11' über die Seitenflächen der Messerhälften 1', 10' hervorsteht. Der Vorsprung ist hierbei so vorgesehen, dass der in Figur 2 gezeigte Abstand A jeweils zur Hälfte ausgebildet wird (½ x A).

Die Isolierungen sind beispielsweise mittels Schraubverbindungen an den Messerhälften 1', 10' angebracht. Ferner ist es vorgesehen, dass die erste Messerhälfte 1' an einer Rückfläche nicht am Halter 3 anliegt, sondern ein ausreichender Anstand zum Halter 3 vorgesehen ist.

In Figur 3a ist eine Draufsicht auf die erste Messerhälfte 1 gezeigt, die mit dem Halter 3 fest verbunden ist. Hierbei ist die V-förmig ausgebildete Schneidfläche S1 dargestellt, die zum Durchtrennen des Kabelmantels verwendet wird. Hierbei ist die erste Messerhälfte 1 in Figur 3a in einem Zustand gezeigt, in dem die Messerhälften 1, 10 nicht mit dem Kabel K in Kontakt stehen.

Figur 3b zeigt eine weitere Variante einer Messerhälfte 1", bei der zusätzlich zur Schneidkante S1 zwei abgesetzte Bereiche 6, 7 vorgesehen sind. Im Bereich dieser abgesetzten Bereiche 6, 7 können Gleitblöcke angebracht werden oder eine Beschichtung aufgetragen sein, die aus einem nicht leitenden Material bestehen. Auf diese Weise wird sichergestellt, dass bei Abisolieren des Kabelmantels K1 von der Kabelader K2 die erste und zweite Messerhälfte 1", 10" bei einem Kontakt aneinander keine leitende Verbindung herstellen. Ein solcher Kontakt kann auftreten, wenn der Abstand A sehr gering gewählt wird, und beim Abziehen des Kabelmantels beim Abisolieren eine Durchbiegung der ersten und zweiten Messerhälfte stattfindet.

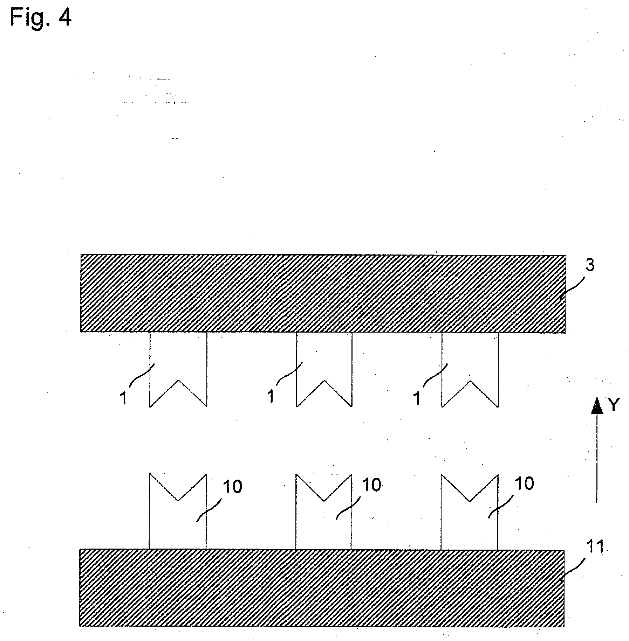

In Figur 4 zeigt schematisch eine Abisoliervorrichtung, die mehrere erste Messerhälften 1 sowie mehrere zweite Messerhälften 10 aufweist. Mit einer solchen Vorrichtung können in einem Arbeitsgang mehrere Kabelenden gleichzeitig abisoliert werden, indem die ersten Messerhälften 1 und die zweiten Messerhälften 10 zueinander bewegt, und anschließend in einer zur Längsrichtung der Kabel K parallelen Richtung ausgestellt werden.

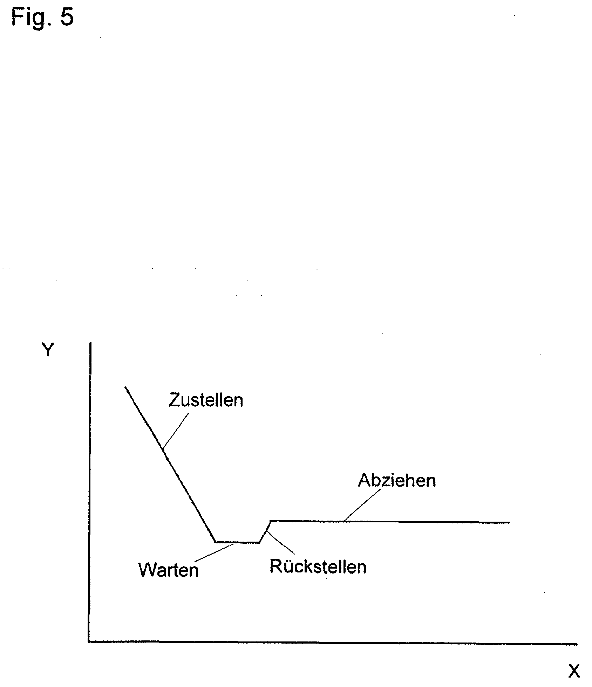

In Figur 5 ist ein Diagramm dargestellt, das die Bewegung der ersten und zweiten Messerhälfte 1, 10 (bzw. 1', 10') zeigt, wobei die erste und zweite Messerhälfte 1, 10 aufeinander zu bewegt werden.

Hierbei teilt sich der Abisoliervorgang in vier Phasen ein. Zuerst werden die Messerhälften 1, 10 zugestellt, und dringen dabei durch den Kabelmantel K1 ein. Nach dem Zustellen verbleiben die Messerhälften 1, 10 kurze Zeit in dieser Position, sodass die Schneidkanten S1, S10 den Kabelmantel K1 sicher durchdringen können. Dies ist vorteilhaft, da der Kabelmantel K1 aus einem elastischen Material besteht und bei der Zustellbewegung zurückweicht, ohne durchtrennt zu werden. Anschließend werden die Messerhälften 1, 10 wieder um einen kleineren Abstand zurück gestellt, und dann in dieser Position in einer zur Längsrichtung des Kabels K parallelen Richtung verschoben. Auf diese Weise wird der Kabelmantel K1 von der Kabelader K2 abgezogen.

Ein bevorzugtes Verfahren zum Abisolieren stellt sich demnach wie folgt dar: Zustellen von Messerhälften 1, 10 derart, dass ein Kabelmantel K1 abschnittsweise durchtrennt wird, Bewegen der Messerhälften 1, 10 in einer zur Längsrichtung des Kabels K parallelen Richtung, und Erfassen eines Stromflusses zwischen der ersten Messerhälfte 1 und der zweiten Messerhälfte 10. Wird ein Stromfluss zwischen der ersten Messerhälfte 1 und der zweiten Messerhälfte 10 erfasst, so wird festgestellt, dass der Abisoliervorgang fehlerhaft war.

Ferner ist es bevorzugt, dass vor dem Bewegen der Messerhälften 1, 10 in einer zur Längsrichtung des Kabels K parallelen Richtung die Messerhälften 1, 10 um ein kleines Maß zurückgestellt werden (voneinander weg bewegt werden). Vor diesem Schritt können die Messerhälften jedoch über einen definierten Zeitraum in ihrer Position gehalten werden. Auf diese Weise wird ein sicheres Durchtrennen des Kabelmantels K1 erreicht, der auf Grund des elastischen Materials beim Durchführen der Trennbewegung etwas zurückweicht.

## Patentansprüche

1. Abisoliervorrichtung zum Abisolieren eines Kabelmantels (K1) eines Kabels (K) mit einer ersten Messerhälfte (1; 1') und einer zweiten Messerhälfte (10; 10'), die in einer ersten Richtung (Y) aufeinander zu bewegbar sind;
die zueinander weisenden Seitenflächen der ersten und zweiten Messerhälfte (1, 10; 1', 10') sind in einer zur ersten Richtung im Wesentlichen senkrechten zweiten Richtung (X) mit einem Abstand (A) voneinander beabstandet,
**dadurch gekennzeichnet, dass**
an der ersten Messerhälfte (1; 1') und der zweiten Messerhälfte (10; 10') eine Spannung angelegt ist, und die Abisoliervorrichtung ferner eine mit der ersten Messerhälfte (1; 1') und der zweiten Messerhälfte (10; 10') verbundene Auswerteeinheit (20) aufweist, die einen Stromfluss durch die erste Messerhälfte (1; 10') und die zweite Messerhälfte (10; 10') erfassen kann.

2. Abisoliervorrichtung gemäß Anspruch 1, bei der die erste Messerhälfte (1; 1') und die zweite Messerhälfte (10; 10') jeweils eine V-förmige Schneidkante (S1, S10) aufweisen.

3. Abisoliervorrichtung gemäß Anspruch 1 oder 2, bei der an den Messerhälften (1, 10; 1', 10') Anschlüsse (4, 13) angebracht oder integral mit den Messerhälften (1, 10) ausgestaltet sind, über die die Auswerteeinheit (20) mit der jeweiligen Messerhälfte (1, 10; 1', 10') verbunden ist.

4. Abisoliervorrichtung gemäß einem der vorangegangenen Ansprüche, bei der eine Isolierung (2, 11) der ersten und/oder zweiten Messerhälfte im Wesentlichen L-förmig ausgebildet ist, sodass ein Längsbereich (2a, 11a) an einer Seitenfläche der Messerhälfte (1, 10; 1', 10') anliegt, und ein Querbereich (2b, 11b) an einer Rückfläche der Messerhälfte (1, 10; 1', 10') anliegt.

5. Abisoliervorrichtung gemäß einem der Ansprüche 1-3, bei der eine Isolierung der ersten und/oder zweiten Messerhälfte durch eine Beschichtung eines Abschnitts der ersten Messerhälfte (1; 1') und/oder der zweiten Messerhälfte (10; 10') ausgebildet ist.

6. Abisoliervorrichtung gemäß einem der Ansprüche 1-3, bei der die erste Messerhälfte (1; 1') und/oder die zweite Messerhälfte (10; 10') eine Ausnehmung (1a', 10a') aufweist, in die die als Block ausgebildete Isolierung (2', 11') eingelegt und befestigt wird, wobei eine Isolierung (2', 11') über eine Seitenfläche der Messerhälfte (1', 10') hervorsteht.

7. Abisoliervorrichtung gemäß einem der vorangegangenen Ansprüche, bei der die erste Messerhälfte (1; 1') mit einer ersten Isolierung (2; 2') im Wesentlichen gleich der zweiten Messerhälfte (10; 10') mit einer zweiten Isolierung (11; 11') ausgebildet ist.

8. Abisoliervorrichtung gemäß einem der vorangegangenen Ansprüche, bei der die erste Messerhälfte (1; 1') und die zweite Messerhälfte (10; 10') zwei abgesetzte Bereiche (6, 7) mit einer isolierenden Beschichtung aufweisen, in welchen Bereichen (6, 7) sich die erste Messerhälfte (1; 1') und die zweite Messerhälfte (10; 10') beim Abziehen des Kabelmantels abschnittsweise berühren.

9. Abisoliervorrichtung gemäß einem der vorangegangenen Ansprüche, die mehrere erste Messerhälften (1; 1') sowie mehrere zweite Messerhälften (10; 10') aufweist.

10. Abisoliervorrichtung gemäß einem der vorangegangenen Ansprüche, bei der die Auswerteeinheit mit der Kabelader (K2) des zu bearbeitenden Kabels (K) verbunden ist.

## Claims

1. Stripping device for stripping a cable sheath (K1) of a cable (K) using a first cutter half (1; 1') and a second cutter half (10; 10') which can be moved towards one another in a first direction (Y); the side surfaces pointing towards one another of the first and second cutter half (1, 10; 1', 10') are spaced from one another by a distance (A) in a second direction (X) essentially vertical to the first direction, **characterised in that** a voltage is applied to the first cutter half (1; 1') and the second cutter half (10; 10'), and the stripping device further has an evaluating unit (20) connected to the first cutter half (1; 1') and the second cutter half (10; 10') which may record a current flow through the first cutter half (1; 10') and the second cutter half (10; 10').

2. Stripping device according to claim 1, in which the first cutter half (1; 1') and the second cutter half (10; 10') have in each case a V-shaped cutting edge (S1, S10).

3. Stripping device according to claim 1 or 2, in which connections (4, 13) are attached to the cutter halves (1, 10; 1', 10') or designed to be integral with the cutter halves (1, 10), via which the evaluating unit (20) is connected to the particular cutter half (1, 10; 1', 10').

4. Stripping device according to one of the preceding claims, in which insulation (2, 11) of the first and/or second cutter half is designed to be essentially L-shaped so that a longitudinal region (2a, 11a) rests against one side surface of the cutter half (1, 10; 1', 10'), and a transverse region (2b, 11b) rests against a rear surface of the cutter half (1, 10; 1', 10').

5. Stripping device according to one of claims 1-3, in which insulation of the first and/or second cutter half is formed by a coating of a section of the first cutter half (1; 1') and/or the second cutter half (10; 10').

6. Stripping device according to one of claims 1-3, in which the first cutter half (1; 1') and/or the second cutter half (10; 10') has a recess (1a', 10a') into which the insulation (2', 11') formed as a block is inserted and secured, wherein insulation (2', 11') projects beyond a side surface of the cutter half (1', 10').

7. Stripping device according to one of the preceding claims, in which the first cutter half (1; 1') with a first insulation (2; 2') is designed to be essentially the same as the second cutter half (10; 10') with a second insulation (11; 11').

8. Stripping device according to one of the preceding claims, in which the first cutter half (1; 1') and the second cutter half (10; 10') have two offset regions (6, 7) with an insulating coating, in which regions (6, 7) the first cutter half (1; 1') and the second cutter half (10; 10') contact one another in sections during pulling off of the cable sheath.

9. Stripping device according to one of the preceding claims, which has several first cutter halves (1; 1') and several second cutter halves (10; 10').

10. Stripping device according to one of the preceding claims, in which the evaluating unit is connected to the cable conductor (K2) of the cable (K) to be processed.

## Revendications

1. Dispositif d'isolation pour l'isolation d'une gaine (K1) d'un câble (K) avec une première moitié de lame (1 ; 1') et une deuxième moitié de lame (10 ; 10') déplaçables l'une vers l'autre dans une première direction (Y) ;
les surfaces latérales opposées l'une à l'autre de la première et de la deuxième moitié de lame (1, 10 ; 1', 10') étant dans une deuxième direction (X) sensiblement perpendiculaire à la première direction espacées l'une de l'autre d'un intervalle (A),
**caractérisé en ce qu'**
une tension est appliquée sur la première moitié de lame (1 ; 1') et la deuxième moitié de lame (10 ; 10'), et
**en ce que** ledit dispositif d'isolation comprend en outre une unité d'évaluation (20) reliée à la première moitié de lame (1 ; 1') et à la deuxième moitié de lame (10 ; 10'), laquelle peut détecter un courant circulant par la première moitié de lame (1 ; 10') et la deuxième moitié de lame (10 ; 10').

2. Dispositif d'isolation selon la revendication 1, où la première moitié de lame (1 ; 1') et la deuxième moitié de lame (10 ; 10') présentent chacune un bord tranchant (S1, S10) en forme de V.

3. Dispositif d'isolation selon la revendication 1 ou 2, où des connexions (4, 13) sont appliquées contre les moitiés de lame (1, 10 ; 1', 10') ou formées d'un seul tenant avec les moitiés de lame (1, 10), au moyen desquelles l'unité d'évaluation (20) est reliée à chaque moitié de lame (1, 10 ; 1', 10').

4. Dispositif d'isolation selon l'une des revendications précédentes, où une isolation (2, 11) de la première et/ou de la deuxième moitié de lame est sensiblement prévue en forme de L, si bien qu'une partie longitudinale (2a, 11a) repose contre une surface latérale de la moitié de lame (1, 10 ; 1', 10'), et une partie transversale (2b, 11b) contre une surface arrière de la moitié de lame (1, 10 ; 1', 10').

5. Dispositif d'isolation selon l'une des revendications 1 à 3, où une isolation de la première et/ou de la deuxième moitié de lame est réalisée par un revêtement d'un segment de la première moitié de lame (1 ; 1') et/ou de la deuxième moitié de lame (10 ; 10').

6. Dispositif d'isolation selon l'une des revendications 1 à 3, où la première moitié de lame (1 ; 1') et/ou la deuxième moitié de lame (10 ; 10') présentent un évidement (1a', 10a'), où est mise en place et fixée l'isolation (2', 11') réalisée comme bloc, une isolation (2', 11') dépassant d'une surface latérale de la moitié de lame (1', 10').

7. Dispositif d'isolation selon l'une des revendications précédentes, où la première moitié de lame (1 ; 1') avec une première isolation (2 ; 2') est prévue sensiblement identique à la deuxième moitié de lame (10 ; 10') avec une deuxième isolation (11 ; 11').

8. Dispositif d'isolation selon l'une des revendications précédentes, où la première moitié de lame (1 ; 1') et la deuxième moitié de lame (10 ; 10') présentent deux zones séparées (6, 7) avec un revêtement isolant, la première moitié de lame (1 ; 1') et la deuxième moitié de lame (10 ; 10') se contactant partiellement dans lesdites zones (6, 7) lors du retrait de la gaine de câble.

9. Dispositif d'isolation selon l'une des revendications précédentes, comportant plusieurs premières moitiés de lame (1 ; 1') ainsi que plusieurs deuxièmes moitiés de lame (10 ; 10').

10. Dispositif d'isolation selon l'une des revendications précédentes, où l'unité d'évaluation est reliée au brin (K2) du câble (K) à usiner.
